# EUROPÄISCHE PATENTSCHRIFT

(11) **EP 4 388 329 B1**
(45) Veröffentlichungstag und Bekanntmachung des Hinweises auf die Patenterteilung: **25.11.2026**
(21) Anmeldenummer: 22801134.2
(22) Anmeldetag: 12.10.2022
(51) Int. Cl.: G01R 31/367, G01R 31/385, G01R 31/389, G01R 31/392, G01R 31/3828, H02J 7/50

(54) **VERFAHREN ZUR BEURTEILUNG EINER ELEKTRISCHEN SPEICHERZELLE**
METHOD FOR ASSESSING AN ELECTRICAL STORAGE CELL
PROCÉDÉ D'ÉVALUATION D'UN ÉLÉMENT D'ACCUMULATEUR ÉLECTRIQUE

(30) Priorität: 25.10.2021 EP 21204511
(43) Veröffentlichungstag der Anmeldung: 26.06.2024
(73) Patentinhaber: Siemens Aktiengesellschaft, 80333 München (DE)
(72) Erfinder: SCHULTE, Sascha, 91315 Höchstadt (DE); BALDAUF, Manfred, 91056 Erlangen (DE)
(74) Vertreter: Siemens Patent Attorneys
(86) Internationale Anmeldenummer: PCT/EP2022/078344
(87) Internationale Veröffentlichungsnummer: WO 2023/072592

(56) Entgegenhaltungen:
- EP-A1- 3 893 316
- CN-B- 109 782 190
- DE-A1- 102017 218 715
- JP-A- 2015 094 726
- US-A1- 2016 069 963
- US-A1- 2020 209 319

## Beschreibung

Die Erfindung betrifft ein Verfahren zur Beurteilung einer elektrischen Speicherzelle nach Patentanspruch 1.

Batteriediagnoseverfahren sind beispielsweise aus DE 10 2017 218715 A1 und US 2020/209319 A1 bekannt. 1

Die Betriebssteuerung von Batterien und Batteriezellen profitiert in wichtigen Bereichen (Lebensdauer, Kosten etc.) von einer möglichst exakten Kenntnis des Zusammenhanges zwischen Benutzungsform und Alterung. Eine wichtige Beschreibung dieses Zusammenhangs sind Alterungskurvenscharen, die gelegentlich auch in Anlehnung an ein Äquivalent aus der Mechanik Wöhlerkurven genannt werden, in der einer Zyklustiefe (DoD) die erwartbare Lebensdauer zugeordnet wird.

Die Ermittlung dieser Alterungskurvenscharen ist mit klassischen Methoden sehr teuer und teilweise sogar mit der Zerstörung der zu prüfenden Speicherzelle verbunden. Dabei wird beispielsweise bei einer Zelle zu verschiedenen Entladetiefen (DoD) und verschiedenen Ladezuständen (SoC) die maximale mögliche Anzahl von Ladezyklen gemessen, bis die entsprechende Speicherzelle defekt ist. Dies wird wiederum pro Datenpunkt der Kurvenschar mit einer Vielzahl von Speicherzellen wiederholt und für jeden Punkt ein Mittelwert aus den getesteten Speicherzellen ermittelt. Es ist nachvollziehbar, dass dieses Vorgehen zwar nützlich ist, um Rückschlüsse zu erzielen, in welchem Belastungsbereich ein Typ einer Speicherzelle typischerweise eingesetzt werden soll. Diese Kurvenschar ist jedoch für jeden Typ von Speicherzellen anzufertigen, kleinere Änderungen in der Auslegung und Konstruktion oder Produktion erfordern in der Regel wiederum das Anfertigen einer entsprechenden Alterungskurvenschar.

Damit existiert ein Interessenskonflikt mit dem Wunsch, eine derartige Messung jeder ausgelieferten Speicherzelle individuell zuordnen zu können und so eine optimale Steuerung/Regelung jeder Batterie zu ermöglichen. Alternativ kann eine derartige Messung verallgemeinert dem jeweiligen Bautyp zugeordnet werden, ohne dabei die individuellen Varianzen zu berücksichtigen.

Die Aufgabe der Erfindung besteht darin, eine Prüfmethode für eine Speicherzelle bereitzustellen, bei der die Speicherzelle nur wenig belastet wird und die eine hohe Aussagekraft über ihre individuelle elektrochemische Charakteristik zulässt.

Die Lösung der Aufgabe besteht in einem Verfahren zur Beurteilung einer Speicherzelle mit den Merkmalen des Patentanspruchs 1.

Das Verfahren gemäß Patentanspruch 1 weist dabei folgende Verfahrensschritte auf.
a) Erstellen eines Referenzdatensatzes über das Alterungsverhalten einer einzelnen Referenzspeicherzelle eines bestimmten Typs in Bezug auf ihr Lade- und Endladeverhalten, wobei Datenpunkte des Referenzdatensatzes zum Alterungsverhalten drei Größen miteinander verknüpfen, nämlich eine Entladetiefe, einen Ladezustand und eine Anzahl der hierfür möglichen äquivalenten Vollzyklen der Referenzspeicherzelle
b) Erstellen eines weiteren Referenzdatensatzes einer zweiten Referenzspeicherzelle desselben Typs
c) Messen einer elektrochemischen Betriebscharakteristik einer jeden Referenzspeicherzelle, zu der ein Referenzdatensatz erstellt wird und Verknüpfen dieser Betriebscharakteristik mit dem jeweiligen Referenzdatensatz
d) Hinterlegen von mindestens zwei Referenzdatensätze mindestens zweier Referenzspeicherzellen desselben Typs sowie die dazugehörigen Verknüpfungen der Betriebscharakteristik in einer Datenbank,
e) Messen der elektrochemischen Betriebscharakteristik einer Speicherzelle und
f) Vergleich der gemessenen Betriebscharakteristik der Speicherzelle mit den in der Datenbank hinterlegten Betriebscharakteristiken der Referenzspeicherzellen und
g) Zuordnung der Speicherzelle an Hand eines Zuordnungsschlüssels zu einem der in der Datenbank hinterlegten Betriebscharakteristiken und dem damit verknüpften Referenzdatensatz.

Der Vorteil des beschriebenen Verfahrens gegenüber dem Stand der Technik besteht darin, dass die Alterungskurven in Form des mittelwertbasierten Referenzdatensatzes nicht für eine Vielzahl von Speicherzellen durchgeführt wird und aus den Messwerten oder Messkurven der einzelnen Referenzspeicherzellen kein Mittelwert gebildet wird. Vielmehr wird lediglich jeweils eine Referenzspeicherzelle herangezogen, aus der jeweils ein Referenzdatensatz zu ihrem Alterungsverhalten erstellt wird. Die Informationen zur Referenzspeicherzelle (Referenzdatensatz) werden zusätzlich mit einem an dieser messtechnisch ermittelten elektrochemischen Betriebscharakteristikum verknüpft.

Der Begriff zwei oder mehr Speicherzellen "desselben Typs" bedeutet, dass es sich um im Wesentlichen baugleiche Speicherzellen handelt, die sich allerdings im Rahmen von produktionstechnischen Toleranzen unterscheiden. Insbesondere die elektrochemische Zusammensetzung der einzelnen Speicherzellen ist dabei im Rahmen der Fertigungstoleranzen gleich. Die Referenzspeicherzellen und die mittels des Verfahrens beurteilten Speicherzellen sind demnach vom selben Typ.

Im Weiteren müssen betrachtete Speicherzellen, die beispielsweise nach ihrer Herstellung auf ihre Charakteristik getestet werden, lediglich auf eine, technisch relativ unaufwendig zu ermittelnde elektrochemische Betriebscharakteristik hin geprüft werden, die die Zelle nur minimal belastet. Es kann dabei aus der hinterlegten Datenbank, in der eine Mehrzahl (mindestens zwei) von getesteten Referenzspeicherzellen mit ihrer jeweiligen Referenzdatensätzen zum Alterungsverhalten und korrespondierenden Betriebscharakteristik hinterlegt sind, auf den Referenzdatensatzes geschlossen werden, der mit der Betriebscharakteristik der betrachteten Speicherzelle am besten übereinstimmt. Es hat sich herausgestallt, dass die Speicherzellen mit ähnlichen elektrochemischen Betriebscharakteristiken ähnliche Alterungsverhalten aufweisen. Daher ist die Verknüpfung zwischen zwei Speicherzellen mit ähnlichen Betriebscharakteristiken dazu geeignet, mit einer ausreichend guten Näherung auf das Alterungsverhalten der entsprechenden Referenzspeicherzelle und deren Referenzdatensatz zu schließen und diesen für betrachtete Speicherzelle heranzuziehen.

Nach der Betrachtung dieser bestmöglichen Übereinstimmung kann beispielsweise und bevorzugt eine Einsatzspezifizierung der Speicherzelle in einem Batteriespeichersystem erfolgen. Oder es kann die betrachtete Speicherzelle mit einer für sie optimalen Steuerung oder Regelungsanweisung verknüpft werden, die dann im späteren Einbau der Zelle in einem größeren System individuell berücksichtigt werden kann.

In der Erfindung werden für Datenpunkte des Referenzdatensatzes zum Alterungsverhalten drei Größen miteinander verknüpft, nämlich eine Entladetiefe (DoD), einen Ladezustand (SoC) und eine Anzahl (N) der hierfür möglichen äquivalenten Vollzyklen der Referenzspeicherzelle. Unter äquivalenten Ladezyklen wird hierbei folgendes verstanden, Z.B. 10 Ladezyklen mit 10% entsprechen einem äquivalenten Vollzyklus, analog dazu wären 4 Zyklen zu 25 % ein äquivalenter Vollzyklus. Eine derartige Kombination von Datenpunkten ergibt einen sehr großen Informationsinhalt bei der Übertragung auf die weitere Steuerung der betrachteten Speicherzelle. Dabei ist es zweckmäßig, mindestens 5 derartige Datenpunkt in einem Referenzdatensatz aufzunehmen. Das heißt, es sollten bevorzugt für zumindest fünf Kombinationen aus SoC und DoD jeweils eine Ermittlung der maximalen Ladezyklen der Referenzspeicherzelle erfolgen.

Ergänzend wäre es auch möglich, die Stromstärke des Lade- oder Entladestroms und/oder die Temperatur beim Lade- oder Entladevorgang als Datenpunkte in den Referenzdatensatz aufzunehmen.

Die Anzahl der betrachteten Referenzspeicherzellen und der daraus resultierenden Anzahl an korrespondierenden Referenzdatensätzen sollte naturgemäß relativ hoch sein, um für jede betrachtete Speicherzelle eine möglichst hohe Auswahl für eine möglichst gute Zuordnung ihrer Betriebscharakteristik zu haben. Andererseits spricht der hohe technische Aufwand und somit auch der hohe Kostenaufwand für eine möglichst geringe Anzahl von Referenzdatensätzen für Referenzspeicherzellen, weshalb zwar mindestens zwei Referenzspeicherzellen betrachtet werden und in der Datenbank abgespeichert werden, wobei es bevorzugt mindestens fünf Referenzspeicherzellen sind, deren Referenzdatensätze in der Datenbank gespeichert werden. Mit mindestens 20 Referenzdatensätzen aus 20 Referenzspeicherzellen hat man eine sehr gute Auswahl an Referenzdatensätzen für eine gute Zuordnung der überprüften Speicherzellen.

Für die Erstellung der Referenzdatensätzen zum Alterungsverhalten der Referenzspeicherzellen wird in einer bevorzugten Ausgestaltungsform der Erfindung folgendes Verfahren genutzt. Das Verfahren zum Ermitteln wenigstens eines mittleren Kapazitätsverlusts eine Referenzspeicherzelle umfasst mehrere Schritte. In einem ersten Schritt a) erfolgt das Messen wenigstens zweier Lastzyklen des Batteriespeichers mittels einer Hoch-Präzisions-Coulometrie-Vorrichtung (HPC), wobei ein einzelner Lastzyklus ein erstes Entladen umfasst, bei dem eine erste Ladungsmenge von einem ersten Ladungszustand zu einem zweiten Ladungszustand gemessen wird. Es erfolgt ein sich anschließendes erstes Laden, bei dem eine zweite Ladungsmenge von dem zweiten Ladungszustand zu einem dritten Ladungszustand gemessen wird. Anschließend erfolgt ein zweites Entladen, bei dem eine dritte Ladungsmenge von dem dritten Ladungszustand zu einem vierten Ladungszustand gemessen wird. Das Laden und Entladen im Lastzyklus erfolgen zwischen einer unteren Spannung und einer oberen Spannung des Batteriespeichers. In einem zweiten Schritt b) erfolgt das Bestimmen einer ersten Ladungs-verschiebung mittels einer Differenz des vierten Ladungszustands und des zweiten Ladungszustands und dem Bestimmen einer zweiten Ladungsverschiebung mittels einer Differenz des dritten Ladungszustands und des ersten Ladungszustands. In einem dritten Schritt c) erfolgt das Bestimmen eines Kapazitätsverlusts aus der Differenz der ersten Ladungsverschiebung und der zweiten Ladungsverschiebung, wobei der erste Schritt a), der zweite Schritt b) und der dritte Schritt c) durchgeführt werden, bis der Kapazitätsverlust im Wesentlichen konstant ist. Anschließend wird der mittlere Kapazitätsverlust basierend auf wenigstens zwei Kapazitätsverlusten ermittelt.

Das beschriebene Verfahren, das im Weiteren vereinfachend als HPC Verfahren bezeichnet wird, weist gegenüber dem Stand der Technik den Vorteil auf, dass durch wesentlich geringere Lade- und Entladevorgänge Rückschlüsse auf die maximalen Ladezyklen einer Referenzspeicherzelle getroffen werden können. Somit ist es durch das beschriebene Verfahren deutlich schneller möglich, zu aussagekräftigen Werten über das Alterungsverhalten der Referenzspeicherzelle zu kommen ohne dass die dabei in jeden Fall zerstört wird. Das HPC Verfahren ermöglicht es wesentlich schneller zu Alterungskurvenscharen oder zu Referenzdatensätzen für Referenzspeicherzellen zu kommen und diese auch detailliert darzustellen.

In einer weiteren Ausgestaltungsform der Erfindung erfolgt die Ermittlung der elektrochemischen Betriebscharakteristik in Form einer elektrochemischen Impedanzspektroskopie (EIS). Die EIS ist ein etabliertes technisches Verfahren, das bei Speicherzellen ohne großen technischen Aufwand angewandt werden kann und diese dabei in Hinblick auf ihre Alterung kaum belastet. Die EIS ist eine Methode, die standardmäßig für jede Speicherzelle nach der Herstellung angewendet werden kann. Üblicherweise wird die EIS grafisch in Form eines Nyquistdiagramm dargestellt. Diese in der Elektrotechnik übliche Darstellungsmethode für Impedanzen zeigt beispielsweise auf der X-Achse den Realteil des als komplexe Zahl dargestellten Impedanzwertes und auf der Y-Achse den Imaginärteil des Impedanzwertes.

Dabei kann es auch zweckmäßig sein, dass die Ermittlung der elektrochemischen Betriebscharakteristik unter Betrachtung diskreter Frequenzen eines mittels der Impedanzspektroskopie erhaltenden Impedanzspektrums erfolgt. Hierfür könnten beispielsweise ein bis drei für das elektrochemische Verhalten der Speicherzelle charakteristische Frequenzen aufgenommen werden und ausgewertet werden. Hierfür muss kein ganzes Impedanzspektrum erstellt werden, was Zeit und Herstellungskosten spart. Unter dem Begriff diskret wird dabei verstanden, dass ein sehr schmaler aber nicht unendlich schmaler Frequenzbereich betrachtet wird, der mit üblichen technischen Methoden betrachtet werden kann.

Eine alternative Möglichkeit oder eine zusätzliche Möglichkeit, die elektrochemische Betriebscharakteristik einer Speicherzelle zu prüfen, wäre ein HPC Verfahren, wie es gemäß Patentanspruch 4 beschrieben ist. Hierbei würden gegebenenfalls weniger Iterationsschritte durchgeführt werden, als dies bei der Herstellung des beschriebenen Referenzdatensatzes der Fall ist. Insbesondere könnte dabei auch nur ein, möglichst charakteristischer Datenpunkt des Referenzdatensatzes vermessen werden. Durch die geringere Anzahl der Iterationen würde eine geringere Belastung der Speicherzelle erfolgen und es könnte trotzdem aufgrund des so gemessenen Wertes eine Korrelation zum Referenzdatensatzes herbeigeführt werden.

Eine weitere vorteilhafte Ausgestaltungsform der Erfindung besteht darin, dass elektrochemische Qualitätsklassen für die Speicherzellen definiert werden und nach der Zuordnung der Speicherzelle zu einem Referenzdatensatz, die Speicherzelle einer Qualitätsklasse zugeteilt wird. Hierdurch können die Speicherzellen bei ihrer Anwendung entweder nach ihrer Qualitätsklasse sortiert in definierte Speichereinheiten eingebaut werden. Dabei verfügen die so zusammengesetzten Speichereinheiten beispielsweise über unterschiedliche Leistungsklassen. Andererseits ist es möglich, die Speicherzellen nach ihrer zugeordneten Qualitätsklasse in einer Speichereinheit individuelle anzusteuern. So kann beispielsweise eine Speicherzelle, die eine höhere Anzahl an Vollzyklen erwarten lässt, bei mittlerer Belastung er Speichereinheit gezielt singulär geladen und entladen werden wogegen schwächere Speicherzellen wiederum häufiger geschont werden.

Eine weitere vorteilhafte Ausgestaltungsform der Erfindung besteht darin, dass als Qualitätskriterien für die Qualitätsklassen die maximale Anzahl von äquivalenten Vollzyklen im Referenzdatensatz dient. Dies kann wie beschrieben beispielsweise für gezieltes Ansteuern der Speicherzellen in der Speichereinheit dienen. Alternativ oder zusätzlich zu der maximalen Anzahl Vollzyklen kann das Qualitätskriterien durch das Volumen unter der Kurvenschar, die durch den Referenzdatensatz gebildet wird, charakterisiert werden. Dieses Kriterium kann auch als mittlere Anzahl der möglichen Vollzyklen über alle Datenpunkte des Referenzdatensatzes angesehen werden.

Weitere Ausgestaltungsformen und weitere Merkmale der Erfindung werden anhand der folgenden Figuren näher erläutert. Hierbei handelt es sich um schematische Darstellungen und beispielhafte Ausgestaltungsformen, die keine Einschränkung des Schutzbereichs darstellen.

Dabei zeigen:
- Figur 1: eine Alterungskurvenschar für einen Typ von Speicherzellen nach dem Stand der Technik, bei dem für jedem Punkt der Kurvenfahrt mehrere Speicherzellen untersucht sind.
- Figur 2: im oberen Teil einen Referenzdatensatzes des Alterungsverhaltens einer einzelnen Referenzspeicherzelle und im unteren Teil eine korrespondierende Darstellung einer EIS Messung derselben Zelle.
- Figur 3: die zu Figur 2 analoge Darstellung des Referenzdatensatzes einer weiteren Referenzspeicherzelle und
- Figur 4: die zu den Figuren 2 und 3 analoge Darstellung des Referenzdatensatzes einer wieder anderen Referenzspeicherzelle.
- Figur 5: eine schematische Darstellung einer praktischen Anwendung der Kombinationen des Referenzdatensatzes und der Betriebscharakteristik.

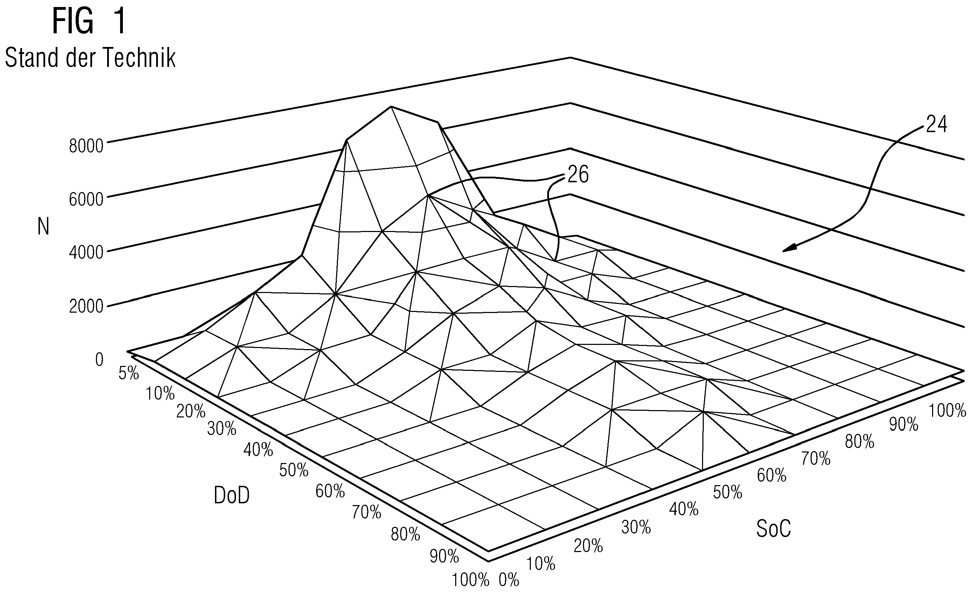

In der Figur 1 ist eine Alterungskurvenschar 24 für elektrische Speicherzellen gemäß dem Stand der Technik dargestellt. Dabei ist in einer Zeichenebene das Verhältnis der Entladungstiefe (DoD) und des Entladezustands bzw. des Ladezustands (SoC) aufgetragen. In Z Richtung ist, bezeichnet mit N, die Anzahl der für die jeweiligen Punkte bezüglich DoD und SoC möglichen maximalen Ladezyklen aufgetragen. Die Grafik zeigt dabei, dass bei einer sehr geringen Entladetiefe von 5 %-10 % um einem mittleren Ladezustand SoC zwischen ca. 40 und 60 % herum die höchste Anzahl an Ladezyklen zu erreichen ist. Umso tiefer die Speicherzelle entladen wird, also umso höher der DoD wird, umso geringer wird die Anzahl der Ladezyklen, bis die Speicherzelle zerstört ist.

Das Besondere an der Grafik gemäß Figur 1 besteht darin, dass für jeden einzelnen dort dargestellten Datenpunkt 26 eine Mehrzahl von Speicherzellen dieser Prozedur unterzogen werden und der Datenpunkt 26 ein Nennmittelwert aus den für alle betrachteten Speicherzellen gewonnenen Werte darstellt. Aus diesem Grund ist das beschriebene Verfahren technisch sehr aufwendig und es muss für jeden einzelnen Typ von Speicherzellen neu erstellt werden. Daher wird aus betriebswirtschaftlichen Gründen die Anzahl der Datenpunkt 26 in der Alterungskurvenschar 24 sehr gering gehalten, weshalb derartigen Kurvenscharen 24 oft nur eine geringe Aussagekraft aufweisen. Ferner handelt es sich bei allen Datenpunkten 26 um Mittelwerte, sodass bei einer betrachteten Speicherzelle, die aus der Produktion entnommen wird, auch nur im Mittel darauf geschlossen werden kann, wie sie sich bei den entsprechenden DoD und SoC Kombinationen verhalten wird. Eine individuelle Betrachtung einer Speicherzelle und somit eine für diese maßgeschneiderte Belastungsteuerung kann auf Basis der Kurvenscharen 24 gemäß des Standes der Technik nicht erfolgen.

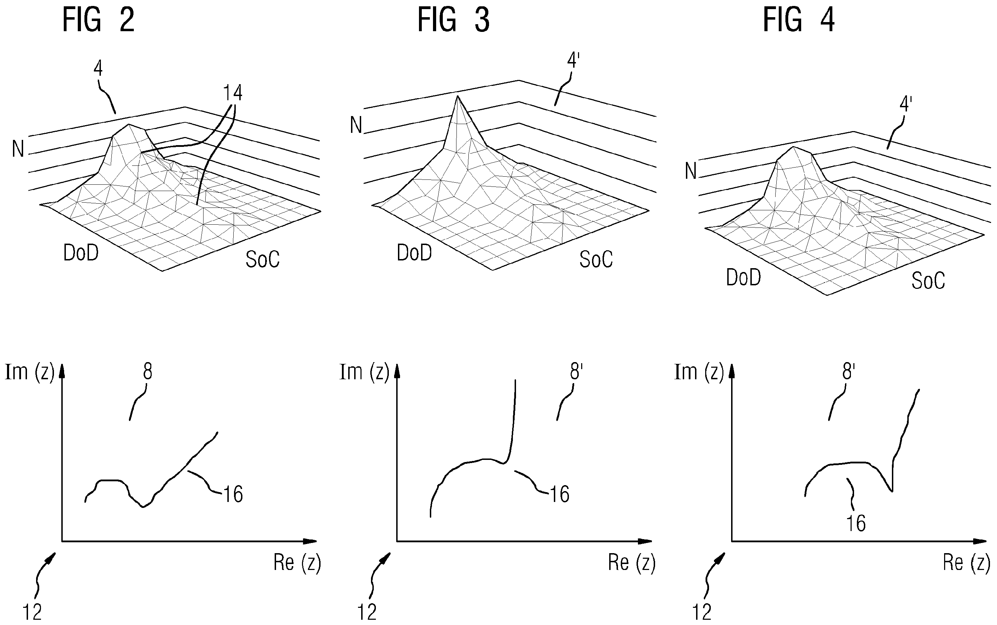

In den Figuren 2 bis 4 sind Kurvenscharen dargestellt, die der Alterungskurvenschar 24 aus Figur 1 grundsätzlich sehr ähnlich sehen, sich von diesen jedoch deutlich unterscheiden. Der Unterschied der Kurvenscharen in den Figuren 2-4, die dort als Referenzdatensätze 4, 4' bezeichnet werden, besteht darin, dass für eine aus der Produktion entnommenen Referenzspeicherzelle 6, 6', der besagt Referenzdatensatzes 4 oder 4'angefertigt wird. Datenpunkte 14 in den Darstellungen gemäß der Figuren 2, 3 und 4 sind keine Mittelwerte aus mehreren Speicherzellen, sondern die Ergebnisse von Messungen eines singulären Referenzspeicherzelle 6, 6'. Dabei ist anzumerken, dass im Weiteren sowohl für die Referenzspeicherzelle 6 zu Unterscheidung, dass es sich nicht um eine identische Speicherzelle handelt, ferner das Bezugszeichen 6' verwendet wird. Bei der Verwendung weiterer Bezugszeichen 6' handelt es sich wiederum um weitere individuelle Speicherzellen, die sich ebenfalls voneinander unterscheiden. Diese Terminologie gilt sowohl für die Referenzdatensatzes 4, die Referenzspeicherzellen 6 sowie die noch zu beschreibende Betriebscharakteristik 8.

Zu der jeweiligen Referenzspeicherzelle 6, 6', wird nun bevorzugt vor der Anfertigung des Referenzdatensatzes 4, 4' eine elektrochemische Betriebscharakteristik 8, 8' aufgenommen, durch die die Referenzspeicherzelle 6, 6' charakterisiert wird. Als bevorzugtes Betriebscharakteristik um 8 hat sich die sogenannte elektrochemische Impedanzspektroskopie 16 herausgestellt. Die Impedanzspektroskopie 16 wird bevorzugt in Form eines Nyquistdiagramm 12 aufgetragen und ist jeweils in den Figuren 2, 3 und 4 im unteren Teil dargestellt. Hierbei wird auf der X-Achse der Realteil der Impedanz Z dargestellt, auf der Y-Achse wird der Imaginärteil dargestellt. Hierbei entsteht für jede Referenzspeicherzelle 6, 6' eine charakteristische Betriebscharakteristik 8, 8', die wiederum eindeutig einem Referenzdatensatz 4, 4' dieser individuellen Referenzspeicherzelle 6, 6' zugeordnet werden kann.

Diese Zuordnung gilt für alle Referenzdatensätze 4, 4', die exemplarisch in den Figuren 2, 3 und 4 dargestellt sind. Hierbei ist zu erkennen, dass alle 3 in den Figuren 2, 3 und 4 dargestellten Referenzdatensätze durchaus individuelle Veränderungen aufweisen, auch wenn sie im Wesentlichen qualitativ ähnlich sind. In den Figuren 2 bis 4 sind lediglich 3 verschiedene Referenzdatensätze 4, 4' dargestellt. Um eine möglichst gute Zuordnung von elektrische Speicherzellen 2, die aus der laufenden Produktion stammen, zu den Referenzdatensätzen 4 machen zu können, ist eine möglichst hohe Anzahl von Referenzdatensätzen 4 und die entsprechend zugeordneten Betriebsmittelcharakteristiken 8 zweckmäßig. Es sollten dabei mindestens fünf, bevorzugt mehr als 20 derartiger Paarungen angefertigt werden. Für die Anzahl der Datenpunkte 14 in den einzelnen Referenzdatensätzen 4 gilt ebenfalls, dass eine möglichst hohe Anzahl von Datenpunkten 14 vorliegen soll. Ein Minimum wird hierbei bei fünf Datenpunkten 14 gesehen, bevorzugt werden auch mehr als 20 Datenpunkte angefertigt.

Für das Anfertigen der Datenpunkte 14 in dem beschriebenen Verfahren kann eine herkömmliche Versuchsreihe von Entlade- und Ladevorgängen anwendet werden, die letztendlich zur Zerstörung der Referenzspeicherzelle 6 führen. Es kann aber im Rahmen einer Optimierung des technischen Aufwandes das bereits beschriebene HPC Verfahren angewendet werden. Auf diese Weise wird der Referenzdatensatzes 4 mit einem deutlich geringeren technischen Aufwand erstellt. Das beschriebene HPC Verfahren kann mit einer geringen Anzahl an Iterationsschritten ebenfalls alternativ oder ergänzend zum Impedanzspektroskopie-Verfahren 16 als Betriebscharakteristik 8 herangezogen werden.

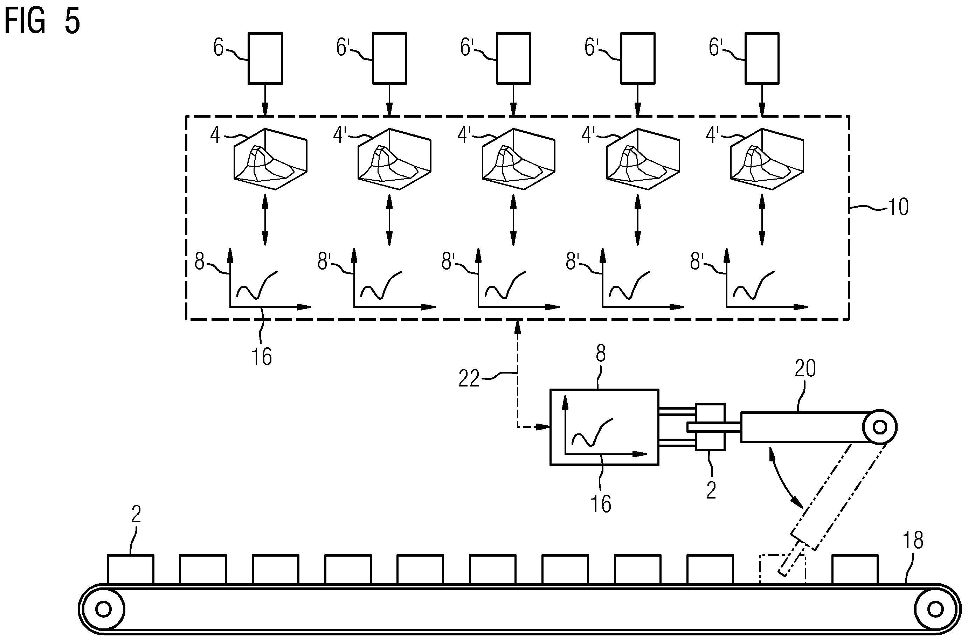

In der Figur 5 ist eine praktische Anwendung der Kombinationen von Referenzdatensatzes 4 und Betriebscharakteristik 8 schematisch dargestellt. Hierbei sind im oberen Teil der Figur 5 eine Mehrzahl von Referenzspeicherzellen 6, 6' untersucht worden, und es sind jeweils ein Referenzdatensatzes 4 sowie eine dazu korrespondierende Betriebscharakteristik 8 mittels einer Impedanzspektroskopie 16 angefertigt und dargestellt. Die Gesamtzahl der Kombination aus Referenzdatensätzen 4 und Betriebs Charakteristik 8 einer jeden untersuchten Referenzspeicherzelle 6 sind in einer Datenbank 10 abgelegt, die in Figur 5 als gestrichelter Kasten um die Gesamtanzahl der Grafen angedeutet ist.

Wird nun eine Vielzahl von Speicherzellen 2 aus der Produktion auf ihre elektrochemische Charakteristik hin untersucht, was in Figur 5 im unteren Teil anhand einer Förderstrecke 18, auf der eine Vielzahl von Speicherzellen 2 befördert werden, angedeutet ist, so wird bevorzugt jede einzelne dieser Speicherzellen 2 bezüglich ihrer Betriebscharakteristik 8 untersucht. Dies ist in Figur 5 mittels einer Robotervorrichtung 20 schematisch angedeutet. D. h., dass bevorzugt zu jeder Speicherzelle 2 eine elektrochemische Impedanzspektroskopie 16 angefertigt wird. Das Anfertigen der Impedanzspektroskopie 16 bedeutet für die Speicherzelle 2 kaum eine nennenswerte elektrochemische Belastung und liefert somit eine Betriebscharakteristik 8, die mit den Betriebscharakteristiken 8 8' in der Datenbank 10 abgeglichen wird. Hierbei wird ein Zuordnungsschlüssel 22 verwendet, der Figur 5 durch den gestrichelten Doppelpfeil angedeutet ist. Bei dem Zuordnungsschlüssel kann es sich um eine speziell für die entsprechenden Grafen ausgebildete künstliche Intelligenz Programmierung handeln, die nach möglichst guten Ähnlichkeiten und Übereinstimmungen nach empirischen Kriterien sucht. Ist eine möglichst hohe Übereinstimmung der gemessenen Betriebscharakteristik 8 der Speicherzelle 2 mit einer Betriebscharakteristik 8 aus der Datenbank 10 ermittelt worden, so kann mit einer guten Genauigkeit auf ein Alterungsverfahren gemäß des zugeordneten Referenzdatensatzes 4 geschlossen werden.

Der Vorteil des Verfahrens besteht nun darin, dass für eine beliebige Speicherzelle 2 nach der Herstellung mit einer hohen Genauigkeit eine individuelle Alterungskurvenschar in Form des Referenzdatensatzes 4 zugeordnet werden kann. Es handelt sich dabei nicht Wahrscheinlichkeiten, die aus Mittelwerten gebildet sind, anhand derer der Typ von Speicherzellen spezifisch altert, sondern es lassen sich individuelle Vorhersagen für die einzelne betrachteten Speicherzelle 2 treffen. Hierin unterscheidet sich das beschriebene Verfahren explizit vom Stand der Technik, in dem lediglich mittlerer Wahrscheinlichkeiten für das Alterungsverhalten angegeben werden.

Dies wiederum ergibt die Möglichkeit, dass für jede individuelle Speicherzelle 2 in ihrer Verwendung auch eine individuelle Belastungssteuerung zugeordnet werden kann. D. h. bei einer Speicherzelle 2, die individuell etwas von ihrem Alterungsverhalten schwächer ausgestaltet ist als eine andere, kann in einem späteren Speichersystem, indem sie final verbaut wird, eine individuelle Speichersteuerung erfolgen. Das bedeutet, dass auch in einem komplexen Speichersystem einzelne Speicherzellen individuell behandelt werden können, sodass sie ihrer individuellen Leistungsfähigkeit und Alterungsbedingungen entsprechend optimal angesteuert werden können. Das führt dazu, dass auch für das entsprechende Speichersystem, beispielsweise einer Speichereinheit für ein Elektrofahrzeug eine höhere Lebensdauer erzielt werden kann. Andererseits ist es auch mit den Erkenntnissen über die individuellen Alterungseigenschaften einer jeden individuellen Speicherzelle 2 möglich, Speichersysteme mit besonders hohen Leistungsmerkmalen zusammenzustellen, sodass Speichersysteme die von außen gesehen baugleich sind, bei unterschiedlichen Leistungsklassen in ihrer Anforderung eingesetzt werden können. So kann beispielsweise ein Elektrofahrzeug mit einem höheren Leistung-Label bei gleicher Bauform des Energiespeichersystems eine höhere Leistung -gegebenenfalls auch nur für kurze Zeit - aufweisen, wenn in diesem Speichersystem entsprechend aussortierte Speicherzellen 2 zusammengefasst sind.

### Bezugszeichenliste

- 2: elektrische Speicherzelle
- 4: Referenzdatensatz
- 6: Referenzspeicherzelle
- 8: elektrische chemische Betriebscharakteristik
- 10: Datenbank
- 12: Nyquistdiagramm
- 14: Datenpunkte
- 16: elektrochemische Impedanzspektroskopie
- 18: Förderstrecke
- 20: Robotervorrichtung
- 22: Zuordnungsschlüssel
- 24: Alterungskurvenschau
- 26: gemittelte Datenpunkte
- DoD: depth of discharge
- SoC: state of charge

## Patentansprüche

1. Verfahren zur Beurteilung einer elektrischen Speicherzelle (2), umfassend folgende Schritte,
a) Erstellen eines Referenzdatensatzes (4) über das Alterungsverhalten einer einzelnen Referenzspeicherzelle (6) eines bestimmten Typs in Bezug auf ihr Lade- und Endladeverhalten,
b) Erstellen eines zweiten Referenzdatensatzes (4') einer zweiten Referenzspeicherzelle (6') desselben Typs,
c) Messen einer elektrochemischen Betriebscharakteristik (8, 8') einer jeden Referenzspeicherzelle (6, 6'), zu der ein Referenzdatensatz (4, 4') erstellt wird und Verknüpfen dieser Betriebscharakteristik (8, 8') mit ihrem Referenzdatensatz (4, 4'),
d) Hinterlegen von mindestens zwei Referenzdatensätze (4, 4') mindestens zweier Referenzspeicherzellen (6, 6') desselben Typs sowie die dazugehörigen Verknüpfungen der Betriebscharakteristik (8, 8') in einer Datenbank (10),
e) Messen der elektrochemischen Betriebscharakteristik (8") einer Speicherzelle (2) und
f) Vergleich der gemessenen Betriebscharakteristik (8") der Speicherzelle (2) mit den in der Datenbank (10) hinterlegten Betriebscharakteristiken (8, 8') der Referenzspeicherzellen (6, 6') und
g) Zuordnung der Speicherzelle (2) anhand eines Zuordnungsschlüssels (22) zu einem der in der Datenbank (10) hinterlegten Betriebscharakteristiken (8, 8') und dem damit verknüpften Referenzdatensatz (4, 4'), **dadurch gekennzeichnet, dass** Datenpunkte (14) des Referenzdatensatzes (4, 4') zum Alterungsverhalten drei Größen miteinander verknüpfen, nämlich eine Entladetiefe ,DoD, einen Ladezustand ,SoC, und eine Anzahl der hierfür möglichen äquivalenten Vollzyklen ,N, der Referenzspeicherzelle.

2. Verfahren nach Anspruch 1, **dadurch gekennzeichnet, dass** der Referenzdatensatz (4) mindestens fünf Datenpunkte mit Verknüpfungen der drei Größen enthält.

3. Verfahren nach einem der vorhergehenden Ansprüche, **dadurch gekennzeichnet, dass** mindestens fünf Referenzdatensätze (4, 4') mit den jeweils korrespondierenden Betriebscharakteristika (8, 8') in der Datenbank (10) hinterlegt sind.

4. Verfahren nach einem der vorhergehenden Ansprüche, **dadurch gekennzeichnet, dass** der Referenzdatensatz zum Alterungsverhalten mittels folgenden Verfahrens erstellt wird:
a) Messen wenigstens zweier Lastzyklen des Batteriespeichers mittels einer Hoch-Präzisions-Coulometrie-Vorrichtung, wobei ein Lastzyklus ein erstes Entladen umfasst, bei dem eine erste Ladungsmenge von einem ersten Ladungszustand zu einem zweiten Ladungszustand gemessen wird, ein sich anschließendes erstes Laden, bei dem eine zweite Ladungsmenge von dem zweiten Ladungszustand zu einem dritten Ladungszustand gemessen wird und ein zweites Entladen, bei dem eine dritte Ladungsmenge von dem dritten Ladungszustand zu einem vierten Ladungszustand gemessen wird, wobei das Laden und Entladen des Lastzyklus zwischen einer unteren Spannung und einer oberen Spannung des Batteriespeichers erfolgt,
b) Bestimmen einer ersten Ladungsverschiebung mittels einer Differenz des vierten Ladungszustands und des zweiten Ladungszustands und Bestimmen einer zweiten Ladungsverschiebung mittels einer Differenz des dritten Ladungszustands und des ersten Ladungszustands,
c) Bestimmen eines Kapazitätsverlusts aus der Differenz der ersten Ladungsverschiebung und der zweiten Ladungs-verschiebung,
- Durchführen der Schritte a) bis c) bis der Kapazitätsverlust in wenigstens zwei aufeinanderfolgenden Lastzyklen nahezu konstant ist,
- Ermitteln eines mittleren Kapazitätsverlusts basierend auf wenigstens zwei Kapazitätsverlusten.

5. Verfahren nach einem der vorhergehenden Ansprüche, **dadurch gekennzeichnet, dass** die Ermittlung der elektrochemischen Betriebscharakteristik (8) in Form einer elektrochemischen Impedanzspektroskopie (16) erfolgt.

6. Verfahren nach Anspruch 5, **dadurch gekennzeichnet, dass** die Ermittlung der elektrochemischen Betriebscharakteristik unter Betrachtung diskreter Frequenzen eines mittels der Impedanzspektroskopie erhaltenden Impedanzspektrums erfolgt.

7. Verfahren nach einem der Ansprüche 1 bis 4, **dadurch gekennzeichnet, dass** die Ermittlung der elektrochemischen Betriebscharakteristik (8) mittels eines Verfahrens gemäß Anspruch 4 a) bis 4 c) erfolgt.

8. Verfahren nach einem der vorhergehenden Ansprüche, **dadurch gekennzeichnet, dass** nach der Zuordnung einer Speicherzelle zu einem Referenzdatensatz eine Einsatzspezifizierung der Speicherzelle in einem Batteriespeichersystem erfolgt.

9. Verfahren nach einem der vorhergehenden Ansprüche, **dadurch gekennzeichnet, dass** elektrochemische Qualitätsklassen für die Speicherzellen (2) definiert werden und nach der Zuordnung der Speicherzelle zu einem Referenzdatensatz (4, 4'), die Speicherzelle (2) einer Qualitätsklasse zugeteilt wird.

10. Verfahren nach Anspruch 9, **dadurch gekennzeichnet, dass** Qualitätskriterien für die Qualitätsklassen durch die maximale Anzahl von äquivalenten Vollzyklen im Referenzdatensatz (4) charakterisiert wird.

11. Verfahren nach einem der der Ansprüche 9 oder 10, **dadurch gekennzeichnet, dass** die Qualitätskriterien durch das Volumen unter der Kurvenschar, die durch den Referenzdatensatz gebildet wird, charakterisiert wird.

## Claims

1. Method for assessing an electrical storage cell (2), comprising the following steps:
a) creating a reference data set (4) relating to the ageing behaviour of an individual reference storage cell (6) of a specific type with regard to the charging and discharging behaviour thereof,
b) creating a second reference data set (4') of a second reference storage cell (6') of the same type,
c) measuring an electrochemical operating characteristic (8, 8') of each reference storage cell (6, 6') for which a reference data set (4, 4') is created, and linking this operating characteristic (8, 8') to the reference data set (4, 4') thereof,
d) saving at least two reference data sets (4, 4') of at least two reference storage cells (6, 6') of the same type and the associated links to the operating characteristic (8, 8') in a database (10),
e) measuring the electrochemical operating characteristic (8") of a storage cell (2) and
f) comparing the measured operating characteristic (8") of the storage cell (2) with the operating characteristics (8, 8') of the reference storage cells (6, 6') saved in the database (10) and
g) assigning the storage cell (2) on the basis of an assignment key (22) to one of the operating characteristics (8, 8') saved in the database (10) and the reference data set (4, 4') linked thereto, **characterised in that** data points (14) in the reference data set (4, 4') relating to the ageing behaviour link three variables to each other, namely a depth of discharge, DoD, a state of charge, SoC, and a number of equivalent full cycles, N, of the reference storage cell that is possible for the respective depth of discharge and state of charge.

2. Method according to claim 1, **characterised in that** the reference data set (4) contains at least five data points with linking of the three variables.

3. Method according to one of the preceding claims, **characterised in that** at least five reference data sets (4, 4') with the respectively corresponding operating characteristics (8, 8') are saved in the database (10).

4. Method according to one of the preceding claims, **characterised in that** the reference data set relating to the ageing behaviour is created by means of the following method:
a) measuring at least two load cycles of the battery store by means of a high-precision coulometer, wherein one load cycle comprises a first discharging, during which a first charge amount from a first state of charge to a second state of charge is measured, followed by a first charging, during which a second charge amount from the second state of charge to a third state of charge is measured, and a second discharging, during which a third charge amount from the third state of charge to a fourth state of charge is measured, wherein the charging and discharging of the load cycle occurs between a lower voltage and an upper voltage of the battery store,
b) ascertaining a first charge displacement by means of a difference between the fourth state of charge and the second state of charge, and ascertaining a second charge displacement by means of a difference between the third state of charge and the first state of charge,
c) ascertaining a capacity loss from the difference between the first charge displacement and the second charge displacement,
- performing the steps a) to c) until the capacity loss is almost constant in at least two consecutive load cycles,
- determining an average capacity loss on the basis of at least two capacity losses.

5. Method according to one of the preceding claims, **characterised in that** the determination of the electrochemical operating characteristic (8) takes the form of an electrochemical impedance spectroscopy (16).

6. Method according to claim 5, **characterised in that** the determination of the electrochemical operating characteristic is effected by considering discrete frequencies of an impedance spectrum that is obtained by means of the impedance spectroscopy.

7. Method according to one of claims 1 to 4, **characterised in that** the determination of the electrochemical operating characteristic (8) is effected by means of a method according to claim 4 a) to 4 c).

8. Method according to one of the preceding claims, **characterised in that** following the assignment of a storage cell to a reference data set, a usage specification of the storage cell in a battery storage system is produced.

9. Method according to one of the preceding claims, **characterised in that** electrochemical quality classes for the storage cells (2) are defined and, after assigning the storage cell to a reference data set (4, 4'), the storage cell (2) is assigned to a quality class.

10. Method according to claim 9, **characterised in that** quality criteria for the quality classes are **characterised by** the maximum number of equivalent full cycles in the reference data set (4).

11. Method according to one of claims 9 or 10, **characterised in that** the quality criteria are **characterised by** the volume beneath the family of curves which is formed by the reference data set.

## Revendications

1. Procédé d'évaluation d'une cellule de stockage électrique (2), comprenant les étapes suivantes :
a) création d'un ensemble de données de référence (4) sur le comportement au vieillissement d'une cellule de stockage de référence (6) individuelle d'un type donné, en ce qui concerne son comportement à la charge et à la décharge,
b) création d'un deuxième ensemble de données de référence (4') d'une deuxième cellule de stockage de référence (6') du même type,
c) mesure d'une caractéristique de fonctionnement électrochimique (8, 8') de chaque cellule de stockage de référence (6, 6'), pour lequel un ensemble de données de référence (4, 4') est créé, et association de cette caractéristique de fonctionnement (8, 8') avec son ensemble de données de référence (4, 4'),
d) enregistrement d'au moins deux ensembles de données de référence (4, 4') provenant d'au moins deux cellules de stockage de référence (6, 6') du même type, ainsi que les associations correspondantes de la caractéristique de fonctionnement (8, 8') dans une base de données (10),
e) mesure de la caractéristique de fonctionnement électrochimique (8") d'une cellule de stockage (2) et
f) comparaison de la caractéristique de fonctionnement (8") mesurée de la cellule de stockage (2) avec les caractéristiques de fonctionnement (8, 8') de la cellule de stockage de référence (6, 6') enregistrées dans la base de données (10) et
g) affectation de la cellule de stockage (2), à l'aide d'une clé d'affectation (22), à l'une des caractéristiques de fonctionnement (8, 8')enregistrées dans la base de données (10) et à l'ensemble de données de référence (4, 4') qui y est associé, **caractérisé en ce que** les points de données (14) de l'ensemble de données de référence (4, 4') relatifs au comportement au vieillissement relient entre elles trois grandeurs, à savoir une profondeur de décharge, DoD, un état de charge, SoC, et un nombre de cycles complets équivalents possibles à cet effet, N, de la cellule de stockage de référence.

2. Procédé selon la revendication 1, **caractérisé en ce que** l'ensemble de données de référence (4) contient au moins cinq points de données avec les associations des trois grandeurs.

3. Procédé selon l'une des revendications précédentes, **caractérisé en ce qu'**au moins cinq ensembles de données de référence (4, 4') accompagnés des caractéristiques de fonctionnement (8, 8') correspondantes sont enregistrés dans la base de données (10).

4. Procédé selon l'une des revendications précédentes, **caractérisé en ce que** l'ensemble de données de référence sur le comportement au vieillissement est établi au moyen de la procédure suivante :
a) mesure d'au moins deux cycles de charge-décharge de la batterie de stockage à l'aide d'un dispositif de coulométrie de haute précision, dans lequel un cycle de charge-décharge comprend une première décharge au cours de laquelle une première quantité de charge est mesurée entre un premier état de charge et un deuxième état de charge, une première charge consécutive, au cours de laquelle une deuxième quantité de charge est mesurée entre le deuxième état de charge et un troisième état de charge, et une deuxième décharge, au cours de laquelle une troisième quantité de charge est mesurée entre le troisième état de charge et un quatrième état de charge, dans lequel la charge et la décharge du cycle de charge-décharge s'effectuent entre une tension minimale et une tension maximale de la batterie de stockage,
b) détermination d'un premier décalage de charge à partir de la différence entre le quatrième état de charge et le deuxième état de charge, et détermination d'un deuxième décalage de charge à partir de la différence entre le troisième état de charge et le premier état de charge,
c) détermination d'une perte de capacité à partir de la différence entre le premier décalage de charge et le deuxième décalage de charge,
- exécution des étapes a) à c) jusqu'à ce que la perte de capacité soit pratiquement constante sur au moins deux cycles de charge-décharge consécutifs,
- calcul d'une perte de capacité moyenne sur la base d'au moins deux pertes de capacité.

5. Procédé selon l'une des revendications précédentes, **caractérisé en ce que** la détermination de la caractéristique de fonctionnement électrochimique (8) s'effectue sous la forme d'une spectroscopie d'impédance électrochimique (16).

6. Procédé selon la revendication 5, **caractérisé en ce que** la détermination de la caractéristique de fonctionnement électrochimique s'effectue en tenant compte des fréquences discrètes d'un spectre d'impédance obtenu par spectroscopie d'impédance.

7. Procédé selon l'une des revendications 1 à 4, **caractérisé en ce que** la détermination de la caractéristique de fonctionnement électrochimique (8) s'effectue au moyen d'un procédé selon les revendications 4 a) à 4 c).

8. Procédé selon l'une des revendications précédentes, **caractérisé en ce que**, après l'affectation d'une cellule de stockage à un ensemble de données de référence, une spécification d'utilisation de la cellule de stockage dans un batterie de stockage est effectuée.

9. Procédé selon l'une des revendications précédentes, **caractérisé en ce que** des classes de qualité électrochimiques sont définies pour les cellules de stockage (2) et, après l'affectation de la cellule de stockage à un ensemble de données de référence (4, 4'), une classe de qualité est attribuée à la cellule de stockage (2).

10. Procédé selon la revendication 9, **caractérisé en ce que** les critères de qualité pour les classes de qualité sont **caractérisés par** le nombre maximal de cycles complets équivalents dans l'ensemble de données de référence (4).

11. Procédé selon l'une des revendications 9 ou 10, **caractérisé en ce que** les critères de qualité sont **caractérisés par** le volume situé sous l'ensemble de courbes formé par l'ensemble de données de référence.
